# EUROPÄISCHE PATENTSCHRIFT

(11) **EP 1 124 259 B1**
(45) Veröffentlichungstag und Bekanntmachung des Hinweises auf die Patenterteilung: **11.02.2009**
(21) Anmeldenummer: 00811198.1
(22) Anmeldetag: 15.12.2000
(51) Int. Cl.: H01L 25/07, H01L 23/373, H01L 23/36

(54) **Kühlvorrichtung für ein Hochleistungs-Halbleitermodul**
Cooling device for a power semiconductor module
Dissipateur de chaleur pour un module semi-conducteur de puissance

(30) Priorität: 11.02.2000 DE 10006215
(43) Veröffentlichungstag der Anmeldung: 16.08.2001
(73) Patentinhaber: ABB Schweiz AG, 5400 Baden (CH)
(72) Erfinder: Kaufmann, Stefan, 5600 Lenzburg (CH)
(74) Vertreter: ABB Patent Attorneys

(56) Entgegenhaltungen:
- EP-A- 0 471 552
- EP-A- 0 661 917
- DE-A- 19 735 531
- US-A- 5 259 436
- US-A- 5 672 433
- US-A- 5 796 049

## Beschreibung

### Technisches Gebiet

Die Erfindung bezieht sich auf das Gebiet der Leistungselektronik. Sie bezieht sich auf eine Kühlvorrichtung für ein Hochleistungs-Halbleitermodul gemäss Oberbegriff des Patentanspruches 1 sowie auf ein Verfahren zur Herstellung einer derartigen Kühlvorrichtung gemäss Oberbegriff des Patentanspruches 7.

### Stand der Technik

Hochleistungs-Halbleitermodule, wie sie beispielsweise aus EP-A-0'597'144 bekannt sind, weisen mehrere Halbleiterbauelemente (z.B. Thyristoren, IGBTs oder Dioden) auf, welche in einem gemeinsamen Gehäuse zu einer logischen Funktionseinheit zusammengefasst sind. Solche Hochleistungs-Halbleitermodule werden heute in einem Spannungsbereich von bis zu 6.5 kV betrieben und müssen entsprechend gekühlt werden. Hierfür sind die Halbleiterbauelemente auf eine gemeinsame Kühlvorrichtung gelötet, welche im allgemeinen von einer Kühlflüssigkeit durchströmt ist. Als Kühlvorrichtungen werden meistens Kühlkörper aus Aluminium verwendet. Aluminium hat jedoch den Nachteil, dass sein thermischer Ausdehnungskoeffizient nicht den entsprechenden Koeffizienten der Halbleiterbauelemente, insbesondere deren elektrischen Isolationsplatten oder den Halbleiterchips, angepasst ist. Dadurch treten mechanische Spannungen auf, welche zu einem Ermüden der Lotschichten zwischen den Halbleiterbauelementen und der Kühlvorrichtung und somit zum Ablösen der elektrischen Kontakte führen.

DE-A-196'43'717 schlägt deshalb eine Kühlvorrichtung vor, dessen thermischer Ausdehnungskoeffizient demjenigen der Halbleiterbauelemente angepasst ist. Hierfür wird eine Kühlvorrichtung verwendet, welche aus einem Metallmatrix-Komposit, insbesondere aus Aluminium-Siliziumkarbid (AlSiC) oder Kupfer-Siliziumkarbid (CuSiC), hergestellt ist. Die Herstellung eines derartigen Metallkeramik-Verbundmateriales ist beispielsweise in James A. Cornie, Advanced Pressure Infiltration Castin Technology Produces Near-Absolute Net-Shape Metal Matrix Composite Components Cost Competitively, Materials Technology, Vo. 10, No. 3/4, März/April 1995 beschrieben.
Vorzugsweise weist diese Kühlvorrichtung Kühlelemente in Form von Noppen oder Rippen auf, um die Kühlfläche zu erhöhen und somit den Wärmeübergang zu verbessern, so dass sie eine relativ komplexe Geometrie besitzt. In einer ersten Ausführungsform ist die Kühlvorrichtung einstückig aus dem Metallmatrix-Komposit gegossen. Derartige Kühlvorrichtungen sind jedoch relativ teuer, da sie inbesondere bei komplexen Geometrien aufwendig herzustellen sind und zudem aus relativ teurem Material bestehen. In einer anderen Ausführungsform besteht lediglich eine Kühlplatte aus dem Metallmatrix-Komposit, der restliche Teil ist aus einem kostengünstigen Material, insbesondere aus Kunststoff gefertigt, wobei die zwei Teile zusammengeklebt werden. Nachteilig an dieser Ausführungsform ist, dass die Klebverbindung altersbedingten Ermüdungserscheinungen unterworfen ist.

Eine weitere Kühlvorrichtung ist aus EP-A-0'661'917 bekannt. Diese Kühlvorrichtung besteht aus einem Kühlerunterteil und einem Kühleroberteil, wobei das Kühlerunterteil mit dem Kühleroberteil stoffschlüssig verbunden ist. Beide Kühlerteile bestehen aus einem Metallmatrix-Komposit (MMC), beispielsweise aus Aluminium-Siliziumkarbid. Die stoffschlüssige Verbindung der Kühlerteile erfolgt während dem Herstellungsprozess. Hierfür werden zuerst keramische Vorformlinge (preforms) der Kühlerteile hergestellt, aufeinanderelegt und anschliessend wird Metall in beide Teile infiltriert. Die gemeinsame Infiltration soll dem Metall erlauben, mittels Kapillarfluss durch die Poren beider Teile zu fliessen und diese so miteinander zu verbinden. Auch diese Kühlvorrichtungen sind aufgrund der aufwendigen Herstellung und aufgrund der Materialwahl relativ teuer. Da die Qualität der Verbindung vom Kapillarfluss abhängt, ist es je nach Form der Kühlerteile zudem schwierig, einen ausreichend dichten Verbund herzustellen.

EP 0 471 552 A1 zeigt eine Kühlvorrichtung für Halbleiterchips mit einem Kühleroberteil in Form einer Kühlplatte aus MMC-Material, auf dem die zu kühlenden Chips angeordnet sind. Zur Herstellung der Kühlvorrichtung wird die MMC-Platte mit einer Aluminium-Schicht beschichtet. Über eine Lotschicht wird die A1-beschichtete MMC-Platte mit einem Kühlerunterteil verbunden.

Eine weitere Kühlvorrichtung ist aus DE-A- 197 35 531 bekannt.

### Darstellung der Erfindung

Es ist deshalb Aufgabe der Erfindung, eine Kühlvorrichtung der eingangs genannten Art zu schaffen, welche kostengünstig und einfach herstellbar ist.

Diese Aufgabe löst eine Kühlvorrichtung mit den Merkmalen des Patentanspruches 1 sowie ein Verfahren zur Herstellung einer Kühlvorrichtung mit den Merkmalen des Patentanspruches 7.

Die erfindungsgemässe Kühlvorrichtung besteht aus einem Kühlerunterteil und einem Kühleroberteil, wobei das Kühleroberteil eine Kühlplatte aus einem Metallmatrix-Komposit, vorzugsweise Aluminium-Siliziumkarbid, aufweist, wobei die Kühlplatte Stirnflächen aufweist. Die Kühlplatte ist an ihren Stirnflächen vollständig von einem Metallrand (21) umgeben. Die zwei Kühlerteile sind dabei über den Metallrand stoffschlüssig miteinander verbunden.

Kühlplatte und Metallrand lassen sich in einem gemeinsamen Herstellungsschritt fertigen, indem bei einer Metall-Infiltration eines Keramik-Vorformlings zur Bildung der Kühlplatte, überschüssiges Metall dazu verwendet wird, um den Metallrand zu bilden.

Dank dem an der Kühlplatte einstückig angeformten Metallrand lässt sich auf einfache Art und Weise eine feste und zeitbeständige Verbindung vom Kühleroberteil mit dem Kühlerunterteil schaffen. Das Kühlerunterteil lässt sich aus kostengünstigem, leicht form- und bearbeitbaren Material, insbesondere aus Aluminium, herstellen. Durch geeignete Materialwahl des Kühlerunterteils lassen sich bei der Verbindung Spannungen und Verwerfungen vermeiden. Vorzugsweise ist das Kühlerunterteil aus demselben Material gefertigt wie das Kühleroberteil. Als Verbindungsmethode wird Reibschweissen bevorzugt, da dies lediglich zu einer lokalen Wärmebeeinflussung der Kühlvorrichtung führt.

Eine derartige Kühlvorrichtung kombiniert die Vorteile der vorbekannten Kühlelemente aus Metallmatrix-Komposit mit den Vorteilen der vorbekannten Aluminiumkühler, wobei sie einfach und kostengünstig herstellbar ist. Durch den speziellen Rand ist es auf einfache Weise mit dem Kühlerunterteil verbindbar, wobei Verwerfungen vermieden werden können.

Weitere vorteilhafte Ausführungsformen gehen aus den abhängigen Patentansprüchen hervor.

### Kurze Beschreibung der Zeichnungen

Im folgenden wird der Erfindungsgegenstand anhand eines bevorzugten Ausführungsbeispiels, welches in den beiliegenden Zeichnungen dargestellt ist, näher erläutert. Es zeigen:
- Figur 1: einen Querschnitt durch eine erfindungsgemässe Kühlvorrichtung;
- Figur 2: eine perspektivische Darstellung der Kühlvorrichtung gemäss Figur 1 von oben und
- Figur 3: einen Querschnitt durch eine Form zur Herstellung einer mit einem Metallrand versehenen Kühlplatte.

### Wege zur Ausführung der Erfindung

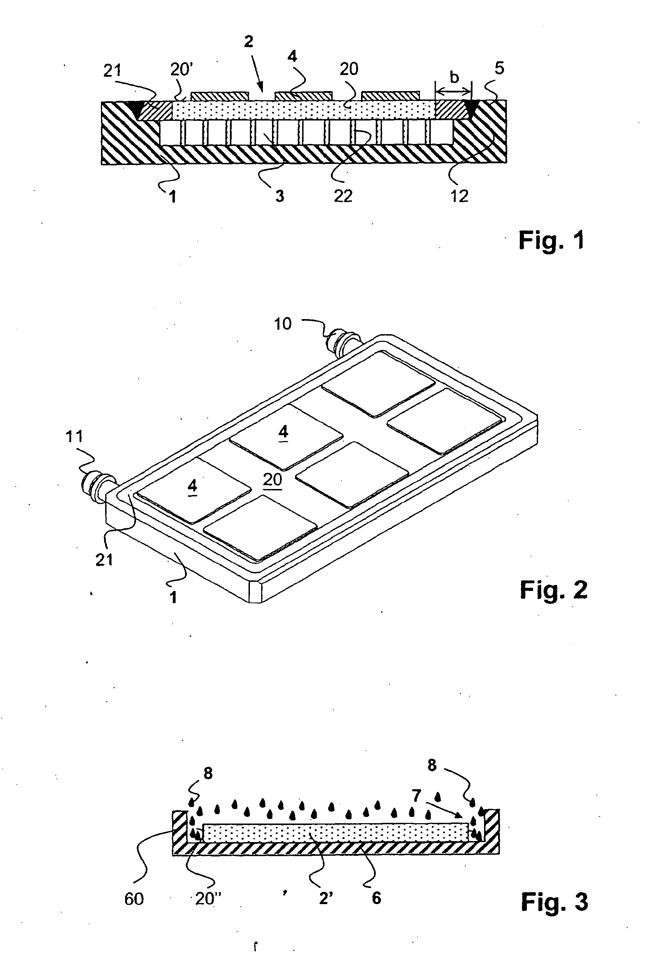

In den Figuren 1 und 2 ist eine erfindungsgemässe Kühlvorrichtung dargestellt. Sie besteht aus einem Kühlerunterteil 1 in Form einer Halbschale und einem im wesentlichen plattenförmigen Kühleroberteil 2. Kühleroberteil 1 und -unterteil 2 umschliessen einen Hohlraum 3, welcher vorzugsweise von einem Kühlmedium, insbesondere Wasser, durchfliessbar ist. Die hierfür notwendigen Ein- und Auslassöffnungen 10,11 sind im Kühlerunterteil 1 angeordnet. Das Kühlerunterteil 1 ist aus einem kostengünstigen, leicht formbaren Material, insbesondere aus einem Metall, beispielsweise Aluminium oder Kupfer, hergestellt. Im hier dargestellten Beispiel weist das Kühlerunterteil 1 einen rechteckigen Grundriss auf, andere Formen sind jedoch auch möglich.

Das Kühleroberteil 2 weist eine Kühlplatte 20 aus einem Metallmatrix-Komposit, insbesondere aus einem Siliziumkarbid-Komposit, auf. Vorzugsweise besteht die Kühlplatte 20 aus Aluminium-Siliziumkarbid (AlSiC). Andere Materialien, wie beispielsweise Kupfer-Siliziumkarbid (CuSiC) oder Kupferkarbid (CuC) kommen jedoch auch in Betracht. Eine dem Kühlerunterteil 1 abgewandte obere Fläche 20' der Kühlplatte 20 ist planar ausgebildet und dient zur Belegung mit Halbleiterbauelementen 4, beispielsweise mit IGBT's, Thyristoren oder Dioden. Die Halbleiterbauelemente 4 werden vorzugsweise direkt auf die Kühlplatte 20 gelötet. Dies ist insbesondere unproblematisch, wenn die Halbleiterbauelemente 4 eine Unterseite aus Aluminiumnitrid (AlN) aufweisen, da dieses Material einen ähnlichen Wärmeausdehnungskoeffizienten wie Aluminium-Siliziumkarbid (AlSiC) besitzt.

Auf der dem Kühlerunterteil 1 zugewandten Unterseite der Kühlplatte 20 sind Kühlelemente 22 in Form von Noppen oder Kühlrippen vorhanden, welcher der Erhöhung des Wärmeübergangs dienen.

Die Kühlplatte 20 ist an ihren Stirnflächen 20" vollständig von einem Metall-rand 21 umgeben. Vorzugsweise besteht der Metallrand 21 aus demselben Metall, wie bereits für das Metallmatrix-Komposit verwendet worden ist, insbesondere ist er aus Aluminium (Al). Vorzugsweise besteht auch das Kühlerunterteil 1 aus demselben Metall.

Typische Dicken für die Kühlplatte 20 betragen 2 - 4 mm. Die Breite b des Metallrandes beträgt typischerweise 5-20 mm. Vorzugsweise weisen der Metallrand 21 und die Kühlplatte 20 dieselbe Dicke auf. Wie in Figur 2 dargestellt, ist die Kühlplatte 20 wie auch der Metallrand 21 rechteckig geformt. Andere Formen sind jedoch möglich.

Das Kühleroberteil 2 liegt auf dem Kühlerunterteil 1 auf, und ist stoffschlüssig mit diesem verbunden. Die Verbindung, welche in Figur 1 mit 5 bezeichnet ist, erfolgt hierbei über den Metallrand 21.

Im hier dargestellten Ausführungsbeispiel ist der Metallrand 21 planar ausgebildet und liegt auf einer umlaufenden Stufe 12 des Kühlerunterteils 1 auf. Andere Formen sind jedoch möglich.

Das Kühleroberteil 2 lässt sich auf einfache Art und Weise fertigen, indem die Kühlplatte 20 aus einem Metallmatrix-Komposit hergestellt wird und an ihr der Metallrand 21 angeformt wird. Die Herstellung des Metallrandes 21 und die Herstellung des Metallmatrix-Komposits lässt sich in demselben Prozessschritt durchführen. Anhand Figur 3 lässt sich eine bevorzugte Variante des Verfahrens beschreiben. Ein Vorformling (preform) in Gestalt einer porösen Keramikplatte 2' wird in eine zu grosse Form 6 gelegt, so dass die Stirnflächen 20" der Keramikplatte 2' mit den Wandungen 60 der Form 6 einen umlaufenden Zwischenraum 7 bilden. Die Keramikplatte 2' wird nun, wie gemäss dem Stand der Technik üblich, mit Metall 8 infiltriert. Dabei wird Metall 8 auch in den Zwischenraum 7 gegossen. Beim anschliessenden Erstarren des Metalls entsteht einerseits die Kühlplatte 20 aus einem Metallmatrix-Komposit und andererseits der Metallrand 21. Durch Wahl der Form 6 lässt sich die Gestalt des Metallrandes 21 wählen.

Zur Fertigstellung der Kühlvorrichtung muss lediglich noch der Metallrand 21 des Kühleroberteils 2 mit dem -unterteil 1 verbunden werden. Hierfür ist, insbesondere bei Verwendung von Aluminium für den Metallrand 21 und den Kühlerunterteil 1, Reibschweissen geeignet.

Die erfindungsgemässe Kühlvorrichtung mit der AlSiC-Platte und dem angegossenen Al-Rand ermöglicht eine kostengünstige und einfache Herstellung und die Gewährleistung einer alterungsbeständigen, dichten Verbindung.

### Bezugszeichenliste

- 1: Kühlerunterteil (Halbschale)
- 10: Einlassöffnung
- 11: Auslassöffnung
- 12: Stufe

- 2: Kühleroberteil
- 2': Keramikplatte
- 20: Kühlplatte
- 20: obere Fläche
- 20": Stirnflächen
- 21: Metall-Rand
- 22: Kühlelemente (Noppen, Rippen)

- 3: Hohlraum

- 4: Halbleiterbauelement

- 5: Verbindung

- 6: Form
- 60: Wandungen

- 7: Zwischenraum

- 8: Metall

- b: Breite des Metallrandes

## Patentansprüche

1. Kühlvorrichtung für ein Hochleistungs-Halbleitermodul,
wobei die Kühlvorrichtung ein Kühlerunterteil (1) und ein Kühleroberteil (2) aufweist,
wobei das Kühleroberteil (2) mit dem Kühlerunterteil (1) stoffschlüssig verbunden ist,
wobei das Kühleroberteil (2) eine Kühlplatte (20) aus einem Metallmatrix-Komposit aufweist zur Belegung mit mindestens einem Halbleiterbauelement (4),
und wobei die Kühlplatte Stirnflächen aufweist,
**dadurch gekennzeichnet, dass** die Kühlplatte (20) an ihren Stirnflächen vollständig von einem angeformten Metallrand (21) umgeben ist und dass die stoffschlüssige Verbindung zwischen Kühleroberteil (2) und Kühlerunterteil (1) über den Metallrand (21) erfolgt.

2. Kühlvorrichtung nach Anspruch 1, **dadurch gekennzeichnet, dass** die Kühlplatte (20) dasselbe Metall aufweist wie der Metallrand (21).

3. Kühlvorrichtung nach Anspruch 1, **dadurch gekennzeichnet, dass** das Kühlerunterteil (1) aus Metall besteht.

4. Kühlvorrichtung nach Anspruch 1, **dadurch gekennzeichnet, dass** der Metallrand (21) und das Kühlerunterteil (1) aus demselben Material bestehen.

5. Kühlvorrichtung nach Anspruch 1, **dadurch gekennzeichnet, dass** die Kühlplatte (20) aus einem Siliziumkarbid-Kompositmaterial besteht.

6. Kühlvorrichtung nach Anspruch 1, **dadurch gekennzeichnet, dass** die Kühlplatte (20) aus Aluminium-Siliziumkarbid (AISiC) und der Metallrand (21) aus Aluminium (Al) besteht.

7. Verfahren zur Herstellung einer Kühlvorrichtung für ein Hochleistungs-Halbleitermodul,
wobei ein Kühlerunterteil (1) und Kühleroberteil (2) geformt werden und Kühleroberteil (2) und Kühlerunterteil (1) stoffschlüssig miteinander verbunden werden,
und wobei zur Bildung des Kühleroberteils (2) eine Kühlplatte (20) aus einem Metallmatrix-Komposit hergestellt wird, welche Kühlplatte (20) Stirnflächen aufweist,
**dadurch gekennzeichnet, dass** ein Metallrand (21) derart an die Kühlplatte (20) angeformt wird, dass die Stirnflächen der Kühlplatte (20) vollständig von dem Metallrand (21) umgeben werden, und dass das Kühleroberteil (2) mittels des Metallrandes mit dem Kühlerunterteil (1) verbunden wird.

8. Verfahren nach Anspruch 7, **dadurch gekennzeichnet, dass** zur Herstellung des Kühleroberteils (2) eine poröse Keramikplatte (2') in eine Form (6) gelegt wird, wobei Stirnflächen (20") der Keramikplatte (2') mit Wandungen (60) der Form (6) einen die Keramikplatte (2') umlaufenden Zwischenraum (7) bilden, dass Metall (8) auf die Keramikplatte (2') und in den Zwischenraum (7) gegossen wird und das Metall (8) ausgehärtet wird.

9. Verfahren nach Anspruch 8, **dadurch gekennzeichnet, dass** das Metall (8) mittels Druckinfiltration eingebracht wird.

10. Verfahren nach Anspruch 7, **dadurch gekennzeichnet, dass** der Metallrand (21) mittels Reibschweissen mit dem Kühlerunterteil (1) verbunden wird.

## Claims

1. Cooling apparatus for a high-power semiconductor module,
with the cooling apparatus having a cooler lower part (1) and a cooler upper part (2),
with the cooler upper part (2) being connected to the cooler lower part (1) by an integral material connection,
with the cooler upper part (2) having a cold plate (20) composed of a metal matrix composite, for at least one semiconductor component (4) to be fitted to,
and with the cold plate (20) having end surfaces,
**characterized**
**in that** the cold plate (20) is completely surrounded by an integrally formed metal edge (21) on its end surfaces, and in that the integral material connection between the cooler upper part (2) and the cooler lower part (1) is produced via the metal edge (21).

2. Cooling apparatus according to Claim 1, **characterized in that** the cold plate (20) is composed of the same metal as the metal edge (21).

3. Cooling apparatus according to Claim 1, **characterized in that** the cooler lower part (1) is composed of metal.

4. Cooling apparatus according to Claim 1, **characterized in that** the metal edge (21) and the cooler lower part (1) are composed of the same material.

5. Cooling apparatus according to Claim 1, **characterized in that** the cold plate (20) is composed of a silicon-carbide composite material.

6. Cooling apparatus according to Claim 1, **characterized in that** the cold plate (20) is composed of aluminum silicon-carbide (AlSiC) and the metal edge (21) is composed of aluminum (Al).

7. Method for producing a cooling apparatus for a high-power semiconductor module,
with a cooler lower part (1) and a cooler upper part (2) being formed, and the cooler upper part (2) and the cooler lower part (1) being connected to one another by an integral material connection,
and in order to form the cooler upper part (2) with a cold plate (20) being produced from a metal matrix composite
**characterized**
**in that** a metal edge (21) is integrally formed on the cold plate (20) such that the end surfaces of the cold plate (20) are completely surrounded by the metal edge (21), and in that the cooler upper part (2) is connected to the cooler lower part (1) by means of the metal edge.

8. Method according to Claim 7, **characterized in that**, in order to produce the cooler upper part (2), a porous ceramic plate (2') is placed in a mould (6), with end surfaces (20") of the ceramic plate (2') forming an intermediate space (7), which runs round the periphery of the ceramic plate (2'), with walls (60) of the mould (6), and **in that** metal (8) is cast onto the ceramic plate (2') and into the intermediate space (7), and the metal (8) is solidified.

9. Method according to Claim 8, **characterized in that** the metal (8) is introduced by means of pressure infiltration.

10. Method according to Claim 7, **characterized in that** the metal edge (21) is connected to the cooler lower part (1) by means of friction welding.

## Revendications

1. Dispositif de refroidissement pour module semi-conducteur à haute puissance,
dans lequel le dispositif de refroidissement présente une partie inférieure (1) de refroidisseur et une partie supérieure (2) de refroidisseur,
la partie supérieure (2) de refroidisseur étant reliée en correspondance de matière à la partie inférieure (1) de refroidisseur,
la partie supérieure (2) de refroidisseur présentant une plaque de refroidissement (20) en un composite à matrice métallique destinée à être occupée par au moins un composant semi-conducteur (4) et
la plaque de refroidissement présentant des surfaces frontales,
**caractérisé en ce que**
les surfaces frontales de la plaque de refroidissement (20) sont entourées complètement par une bordure métallique façonnée (21) et
**en ce que** la liaison en correspondance de matière entre la partie supérieure (2) de refroidisseur et la partie inférieure (1) de refroidisseur s'effectue par l'intermédiaire de la bordure métallique (21).

2. Dispositif de refroidissement selon la revendication 1, **caractérisé en ce que** la plaque de refroidissement (20) présente le même métal que la bordure métallique (21).

3. Dispositif de refroidissement selon la revendication 1, **caractérisé en ce que** la partie inférieure de refroidissement (1) est constituée de métal.

4. Dispositif de refroidissement selon la revendication 1, **caractérisé en ce que** la bordure métallique (21) et la partie inférieure (1) de refroidisseur sont constituées du même matériau.

5. Dispositif de refroidissement selon la revendication 1, **caractérisé en ce que** la plaque de refroidissement (20) est constituée d'un matériau composite à carbure de silicium.

6. Dispositif de refroidissement selon la revendication 1, **caractérisé en ce que** la plaque de refroidissement (20) est constituée de carbure d'aluminium et de silicium (AlSiC) et la bordure métallique (21) d'aluminium (Al).

7. Procédé de fabrication d'un dispositif de refroidissement pour module semi-conducteur à haute puissance,
dans lequel une partie inférieure (1) de refroidisseur et une partie supérieure (2) de refroidisseur sont formées, la partie supérieure (2) de refroidisseur et la partie inférieure (1) de refroidisseur étant reliées l'une à l'autre en correspondance de matière,
une plaque de refroidissement (20) en un composite à matrice métallique étant réalisée pour former la partie supérieure (2) de refroidisseur, cette plaque de refroidissement (20) présentant des surfaces frontales,
**caractérisé en ce que**
les surfaces frontales de la plaque de refroidissement (20) sont complètement entourées par la bordure métallique (21) et
**en ce que** la partie supérieure (2) de refroidisseur est reliée à la partie inférieure (1) de refroidisseur au moyen de la bordure métallique (21).

8. Procédé selon la revendication 7, **caractérisé en ce que** pour réaliser la partie supérieure (2) de refroidisseur, on place une plaque (2') en céramique poreuse dans un moule (6), les surfaces frontales (20'') de la plaque en céramique (2') formant avec les parties (60) du moule (6) un espace intermédiaire (7) qui entoure la plaque en céramique (2'), un métal (8) étant coulé sur la plaque en céramique (2') et dans l'espace intermédiaire (7) et le métal (8) étant durci.

9. Procédé selon la revendication 8, **caractérisé en ce que** le métal (8) est apporté par imprégnation sous pression.

10. Procédé selon la revendication 7, **caractérisé en ce que** la bordure métallique (21) est reliée à la partie inférieure (1) de refroidisseur par soudage par friction.
